# EUROPEAN PATENT APPLICATION

(11) **EP 4 531 118 A1**
(43) Date of publication of application: **02.04.2025**
(21) Application number: 23835488.0
(22) Date of filing: 03.07.2023
(51) Int. Cl.: H01L 33/00, G09F 9/00, G09F 9/33, H01L 33/48

(54) **METHOD FOR MANUFACTURING LED MOUNTING BOARD, CLEANING SOLUTION, AND CLEANING METHOD**

(30) Priority: 06.07.2022 JP 2022108986
(71) Applicant: SHIN-ETSU CHEMICAL CO., LTD., Tokyo 1000005 (JP)
(72) Inventor: MATSUMOTO, Nobuaki, Annaka-shi, Gunma 379-0224 (JP); KITAGAWA, Taichi, Annaka-shi, Gunma 379-0224 (JP); OGAWA, Yoshinori, Tokyo 100-0005 (JP); KONDO, Kazunori, Tokyo 100-0005 (JP)
(74) Representative: Meissner Bolte Partnerschaft mbB
(86) International application number: PCT/JP2023/024640
(87) International publication number: WO 2024/009956

(57) **Abstract**

The present invention is a method for producing an LED mounting substrate, the method includes a step of cleaning an LED chip, being transferred from on top of a sapphire substrate onto a receptor substrate by laser lift-off, with an alkaline cleaning solution. This provides: the method for producing an LED mounting substrate capable of producing the LED mounting substrate by selectively removing metal Ga adhered to the LED chip, which has been transferred from the top of the sapphire substrate onto the receptor substrate by laser lift-off, without dissolving or altering another metal; a cleaning solution usable for this method; a cleaning method for selectively removing the gallium adhered to the LED chip without dissolving or altering the other metal; and a cleaning method for selectively removing gallium from a component having the gallium and a metal other than the gallium on a surface without dissolving or altering the metal other than the gallium.

## Description

### TECHNICAL FIELD

The present invention relates to a method for producing an LED mounting substrate, a cleaning solution, and a cleaning method.

### BACKGROUND ART

In recent years, optical devices made from nitride semiconductors have come to be used as backlights for liquid crystal displays, and displays for signage.

The optical devices, for example, are mass-produced using semiconductor processes on sapphire substrates. When producing a 4-inch display substrate using LEDs known as micro-LEDs, which are 100 µm square or smaller, several million micro-LEDs are required. The micro-LEDs, being tiny devices having a size of several tens of um, are isolated from the sapphire substrate, which is a substrate for epitaxial growth, and are utilized.

In producing steps of micro-LED displays, laser lift-off (LLO) is performed to separate micro-LED chips from the sapphire substrate. The LLO step, for example, is a step of irradiating a GaN layer of the LED chip with an excimer laser to decompose the GaN layer into gaseous N₂ and metal Ga, thereby separating the LED chips from the sapphire substrate. This enables obtaining a receptor substrate having a large number of optical devices arranged on a surface thereof.

The method like this is not limited to the method related to the optical device and can also be applied to produce a receptor substrate on which a plurality of to-be-transferred objects, such as tiny semiconductor devices, are arranged on a surface.

For example, Patent Document 1 proposes a method for accurately transferring to-be-transferred objects from the top of a donor substrate to a receptor substrate using laser irradiation.

### CITATION LIST

### PATENT LITERATURE

Patent Document 1: JP 2020-4478 A

### SUMMARY OF INVENTION

### TECHNICAL PROBLEM

When performing an LLO step, opaque metal Ga unintentionally precipitates on surfaces of separated micro-LED chips. When this metal Ga precipitated on the LED chip is removed using an acidic cleaning solution and the cleaned LED chips are mounted on a substrate, connection failure is generated. As a result of investigations into various possibilities by the present inventors about the cause of this connection failure, the present inventors realized that a shape of a bump before a connection has changed compared to an original shape. In addition, the present inventors have determined that this change is due to dissolution, alteration, or the like of the bump caused by the acidic cleaning solution during the cleaning step.

Here, when the LED chips are subjected to LLO from a sapphire substrate to a receptor substrate, a surface where the bump is provided is adhered to the receptor substrate and protected from the cleaning solution, but the dissolution or alteration is generated during the cleaning step. That is, it is considered that a gap is present between the LED chips and the receptor substrate due to the bump or other differences in level, causing the cleaning solution to enter through this gap, and dissolve and alter the bump.

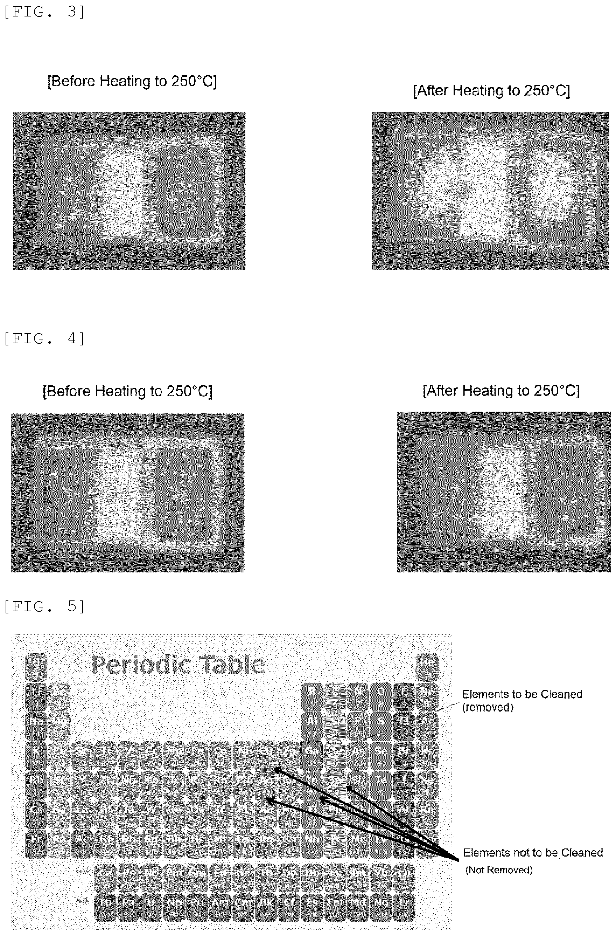

As shown in FIG. 5, metals used for the bump (such as In or SnAgCu-based alloy (SAC)) and Ga (gallium) are often proximate in a periodic table, and it is considered that selective removal of gallium is difficult in a state where the bump and gallium are in contact with the cleaning solution. Accordingly, the present inventors first studied to protect the bump from the cleaning solution by embedding the bump deeply into an adhesive layer of the receptor substrate. However, it is found that while this method can protect the bump from the cleaning solution, separation of the adhesive layer from the bump becomes difficult in the following step.

Here, being proximate to gallium in the periodic table means a position proximate to a position of gallium in the periodic table, which is period 4, group 13. For example, the position may be in a range of periods 3 to 6 and groups 11 to 15 or the position may be in a range of periods 3 to 5 and groups 11 to 14.

In this way, it is found that a cleaning method is required in which metal Ga is selectively removed from components such as the LED chips, which have metal Ga and the metal other than the metal Ga on a surface thereof, without affecting the metal other than the metal Ga. It is also found that a cleaning solution usable for this method is required.

The present invention has been made to solve the above-described problem. An object of the present invention is to provide a method for producing an LED mounting substrate capable of producing the LED mounting substrate by selectively removing metal Ga (hereinafter, may also be simply referred to as "Ga" or "gallium") adhered to LED chips that have been transferred from the top of a sapphire substrate onto a receptor substrate by laser lift-off, without dissolving or altering another metal; a cleaning solution usable for this method; a cleaning method for selectively removing gallium adhered to the LED chips without dissolving or altering the other metal; and a cleaning method for selectively removing gallium from a component having gallium and a metal other than the gallium on a surface without dissolving or altering the metal other than the gallium.

### SOLUTION TO PROBLEM

The present invention has been made to achieve the above-described object. The present invention provides a method for producing an LED mounting substrate, the method comprising a step of cleaning an LED chip, being transferred from on top of a sapphire substrate onto a receptor substrate by laser lift-off, with an alkaline cleaning solution.

According to such a method for producing an LED mounting substrate, a high-quality LED mounting substrate can be produced by removing unnecessary gallium without dissolving or altering a metal such as a bump on the LED chip.

In this case, it is possible that gallium is present on a surface opposite to the receptor substrate of the LED chip that is transferred onto the receptor substrate,
and the gallium is removed in the step of cleaning.

The cleaning step of the inventive method for producing an LED mounting substrate is effective, particularly when removing the gallium from such an LED chip.

In this case, an alkaline concentration of the alkaline cleaning solution can be 0.5 mass% or more but no greater than a saturated concentration or less. In addition, a temperature of the alkaline cleaning solution can be 5°C or more and 80°C or less. Moreover, time for cleaning using the alkaline cleaning solution can be 10 seconds or more and 1 hour or less.

Under such conditions, gallium can be removed selectively with greater stability and reliability.

In this case, a surface of the LED chip on a side to be adhered to the receptor substrate can have a bump.

The inventive method for producing an LED mounting substrate is effective, in particular, when producing the LED mounting substrate having the bump from such an LED chip.

In this case, the bump can have been formed using lead-free solder. Moreover, the bump can contain, as a main component, at least one selected from SnAgCu-based alloy, SnZnBi-based alloy, SnCu-based alloy, SnAgInBi-based alloy, SnZnAl-based alloy, and indium.

The inventive method for producing an LED mounting substrate is effective, in particular, when subjected to the LED chip having such a bump.

In this case, the LED chip transferred onto the receptor substrate can be cleaned by immersing the LED chip along with the receptor substrate in the alkaline cleaning solution.

This enables producing the LED mounting substrate more easily.

The present invention provides a cleaning solution for cleaning an LED chip after transferring thereof onto a receptor substrate by laser lift-off from a sapphire substrate where the LED chip is provided thereon, wherein
the cleaning solution is alkaline.

According to such a cleaning solution, unnecessary gallium can be selectively removed without dissolving or altering a metal such as a bump on the LED chip.

In this case, the cleaning solution can have a pH ranging from 9.5 to 14.0. Moreover, the cleaning solution can be an aqueous solution containing at least one selected from the group consisting of sodium hydroxide, potassium hydroxide, ammonium hydroxide, magnesium hydroxide, tetramethylammonium hydroxide, tetrabutylammonium hydroxide, sodium carbonate, sodium hydrogencarbonate, and potassium acetate.

This enables performing more easy and stable cleaning.

The present invention also provides a cleaning method for cleaning an LED chip isolated from a sapphire substrate by laser lift-off, wherein
an alkaline cleaning solution is used for cleaning.

According to such a cleaning method for cleaning an LED chip, unnecessary gallium can be selectively removed without dissolving or altering a metal such as a bump on the LED chip.

In this case, the LED chip can have been transferred onto a receptor substrate.

The inventive cleaning method is effective, in particular, when cleaning such an LED chip.

The present invention also provides a cleaning method for selectively removing gallium from a component having gallium and a metal other than the gallium on a surface, wherein
the component is cleaned using an alkaline cleaning solution.

According to such a cleaning method for selectively removing gallium, the gallium can be selectively removed without dissolving or altering a metal other than the gallium by an easy method.

In this case, the alkaline cleaning solution can come in contact with the gallium and the metal other than the gallium during cleaning.

This enables selective removal of the gallium without dissolving or altering the metal other than the gallium by an easier method.

In this case, the component can have a substrate-shape, and can be fixed to a different substrate during cleaning,
the gallium can be present on a surface opposite to the different substrate side of the component, and
the metal other than the gallium can be present on the different substrate side of the component.

The inventive cleaning method is effective, in particular, when cleaning such a component.

In this case, the metal other than the gallium can contain at least one selected from the group consisting of aluminum, copper, zinc, silver, indium, tin, and bismuth. In addition, the metal other than the gallium can contain at least one selected from the group consisting of copper, silver, indium, and tin. Moreover, the metal other than the gallium can contain copper, silver, and tin.

Such a metal other than the gallium prevents dissolution or alteration more stably.

### ADVANTAGEOUS EFFECTS OF INVENTION

As described above, according to the inventive method for producing an LED mounting substrate, a high-quality LED mounting substrate can be produced by selectively removing the unnecessary gallium without dissolving or altering the metal such as a bump on each LED chip. This enables decreasing connection failure of the LED chips.

Moreover, according to the inventive cleaning solution, the unnecessary gallium can be selectively removed without dissolving or altering the metal such as a bump on each LED chip. This enables decreasing the connection failure of the LED chips.

Furthermore, according to the inventive cleaning method for cleaning the LED chips isolated from the sapphire substrate by the laser lift-off, the unnecessary gallium can be selectively removed without dissolving or altering the metal such as a bump on each LED chip. This enables decreasing the connection failure of the LED chips.

Moreover, according to the inventive cleaning method for selectively removing the gallium, unnecessary gallium can be selectively removed from the component, which has the gallium and the metal other than the gallium on the surface, without dissolving or altering the metal other than the gallium by the easy method.

Note that, in the present invention, it is preferred that the metal, such as the bump or any metal other than the gallium, is not dissolved or otherwise affected at all. However, when a removal amount of the gallium is larger than a removal amount of the metal such as a bump or any metal other than the gallium, and when the gallium can be selectively removed, the metal such as the bump and any metal other than the gallium may be dissolved or otherwise affected to an extent that remains suitable for practical use.

### BRIEF DESCRIPTION OF DRAWINGS

FIG. 1 is a view describing an example of the cleaning step according to the present invention.
FIG. 2 shows conditions and evaluation results of Examples 1 to 3, and Comparative Examples 1 and 2.
FIG. 3 shows evaluation results of Example 4.
FIG. 4 shows evaluation results of Comparative Example 3.
FIG. 5 is a view (Periodic Table) describing an example of metal elements subject to and not subject to removal by cleaning.
FIG. 6 is a schematic view describing a gap laser lift-off (Gap-LLO).
FIG. 7 is a schematic view describing a contact laser lift-off (Contact-LLO).

### DESCRIPTION OF EMBODIMENTS

Hereinafter, the present invention will be described in detail. However, the present invention is not limited thereto.

As described above, the following are required: a method for producing an LED mounting substrate capable of producing the LED mounting substrate by selectively removing metal Ga adhered to an LED chip, which has been transferred from the top of a sapphire substrate onto a receptor substrate by laser lift-off, without dissolving or altering another metal; a cleaning solution usable for this method; a cleaning method for selectively removing gallium adhered to the LED chip without dissolving or altering the other metal; and a cleaning method for selectively removing gallium from a component having gallium and a metal other than the gallium on a surface without dissolving or altering the metal other than the gallium.

To solve the above problem, the present inventors have earnestly studied and found out that: by using a method for producing an LED mounting substrate, the method including a step of cleaning the LED chip, being transferred from on top of a sapphire substrate onto a receptor substrate by laser lift-off, with an alkaline cleaning solution; a high-quality LED mounting substrate can be produced by selectively removing unnecessary gallium without dissolving or altering a metal such as a bump on the LED chip; and connection failure can be decreased. Based on this finding, the present invention has been completed.

The present inventors also found out that by a cleaning solution for cleaning an LED chip after transferring thereof onto a receptor substrate by laser lift-off from a sapphire substrate where the LED chip is provided thereon, in which the cleaning solution is alkaline, the unnecessary gallium can be selectively removed without dissolving or altering the metal such as a bump on the LED chip and the connection failure of the LED chip can be decreased. Based on this finding, the present invention has been completed.

The present inventors also found out that by a cleaning method for cleaning the LED chip isolated from the sapphire substrate by the laser lift-off, in which an alkaline cleaning solution is used for cleaning, the unnecessary gallium can be selectively removed without dissolving or altering the metal such as a bump on the LED chip. Based on this finding, the present invention has been completed.

The present inventors also found out that by a cleaning method for selectively removing gallium from a component having gallium and a metal other than the gallium on a surface, in which the component is cleaned using an alkaline cleaning solution, unnecessary gallium can be selectively removed without dissolving or altering the metal other than the gallium by an easy method. Based on this finding, the present invention has been completed.

Hereinafter, the description will be given referring to the drawings.

As described above, as a result of earnest studies of the present inventors to solve the above problem, surprisingly, it is found out that the gallium can be selectively removed without affecting the metal other than the gallium even when the bump is not physically protected by using the alkaline aqueous solution as the cleaning solution. The fact that the gallium can be selectively removed by such a simple method, where the alkaline aqueous solution is used as the cleaning solution, can lead to simplification of the production process and improved yield. This is a significant step toward cost reduction of micro-LED displays, which are said to cost tens of millions of yen per unit. Hereinafter, the present invention is described in more detail.

### [Cleaning Solution]

A cleaning solution according to the present invention is an alkaline cleaning solution for cleaning LED chips after transferring thereof onto a receptor substrate by laser lift-off from a sapphire substrate where the LED chips are provided thereon. When the cleaning solution according to the present invention is used, unnecessary gallium can be selectively removed without dissolving or altering a metal such as a bump on each LED chip, and connection failure of the LED chips can be reduced.

Such a cleaning solution is not limited as long as being alkaline but preferably has a pH ranging from 9.5 to 14.0. The Ga can be removed selectively with stability and reliability without dissolving or altering the metal such as a bump on each LED chip.

Moreover, the cleaning solution according to the present invention can be an aqueous solution containing at least one selected from the group consisting of sodium hydroxide, potassium hydroxide, ammonium hydroxide, magnesium hydroxide, tetramethylammonium hydroxide, tetrabutylammonium hydroxide, sodium carbonate, sodium hydrogencarbonate, and potassium acetate. Such an aqueous solution is relatively easy to obtain and handle and is low-cost.

Preferable conditions and the like when cleaning using such a cleaning solution according to the present invention will be described later.

### [Method for Producing LED Mounting Substrate]

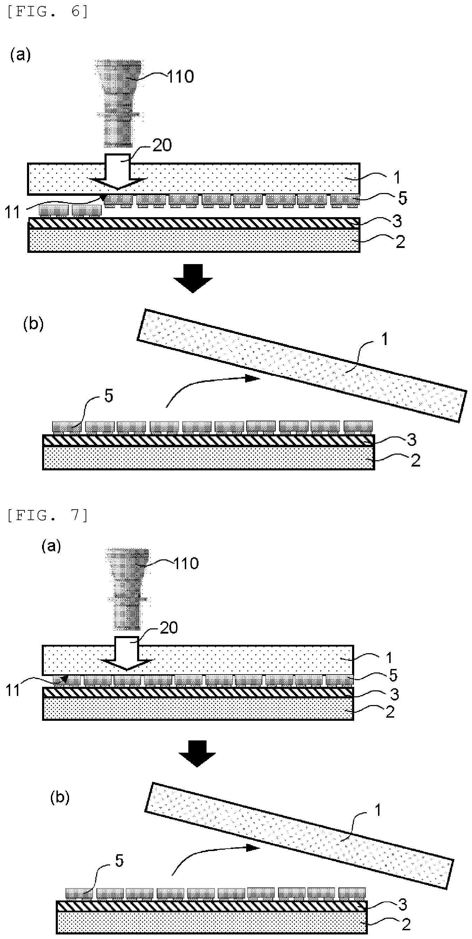

A method for producing an LED mounting according to the present invention includes a step of cleaning LED chips, being transferred from on top of a sapphire substrate onto a receptor substrate by laser lift-off, with an alkaline cleaning solution. The laser lift-off method is not limited to any method but a gap laser lift-off (Gap-LLO) or a contact laser lift-off (Contact-LLO) or the like can be applied. Hereinafter, these methods will be schematically described referring to FIGs. 6 and 7.

In Gap-LLO, first, as shown in FIG. 6(a), for example, a sapphire substrate 1 provided with LED chips 5 and the like that are to-be-transferred objects, and a receptor substrate 2 such as a quartz substrate provided with an adhesive layer 3 such as silicone on a surface are positioned facing each other with a space between the LED chips 5 and the adhesive layer 3, i.e., a gap. In this state, laser 20 is irradiated from a laser oscillator 110 through a surface of a sapphire substrate 1 opposite to the LED chips 5 onto an interface 11 between a plurality of LED chips 5 and the sapphire substrate 1. In general, the laser 20 is sequentially irradiated onto each of the entire surfaces of interface 11 between each LED chip 5 and the sapphire substrate 1, one by one.

For example, in the case of the sapphire substrate 1 provided with a plurality of LED chips 5 each including a gallium nitride-based semiconductor layer such as a GaN layer at the interface 11, the GaN layer is decomposed by irradiating with the laser 20 (ablation). When a bonding strength (such as adhesive strength or joining force) between the LED chips 5 and the sapphire substrate 1 is weakened by ablation, the LED chips 5 are separated from the sapphire substrate 1. Additionally, gas (e.g., nitrogen gas) is generated due to the decomposition of the GaN layer. The separated LED chips 5 are propelled by this gas pressure toward the receptor substrate 2, travel the space between the sapphire substrate 1 and the receptor substrate 2, and reach the adhesive layer 3 on the receptor substrate 2. In this way, the LED chips 5 are transferred onto the receptor substrate 2. Subsequently, as shown in FIG. 6(b), the sapphire substrate 1 is removed. This completes the transfer of the LED chips 5 from the sapphire substrate 1 to the receptor substrate 2.

The Contact-LLO is the same as the Gap-LLO except that, when irradiating with the laser 20, as shown in FIG. 7(a), the sapphire substrate 1 provided with the LED chips 5 that are objects to be transferred, and the receptor substrate 2 provided with the adhesive layer 3 on the surface are positioned facing each other such that the LED chips 5 are brought into direct contact with the adhesive layer 3. After irradiating the laser 20, as shown in FIG. 7(b), the transfer of the LED chips 5 from the sapphire substrate 1 to the receptor substrate 2 is completed by removing the sapphire substrate 1.

In such a LLO step, the metal Ga remains on the components such as the LED chips 5 due to the decomposition of the gallium nitride-based semiconductor layer such as the GaN layer. To remove this metal Ga, in the present invention, the LED chips 5 are cleaned using the alkaline cleaning solution. Consequently, unnecessary gallium can be selectively removed without dissolving or altering a metal such as a bump on each LED chip. As a result, connection failure of the LED chips can be reduced.

The alkaline cleaning solution described above can be applied as an alkaline cleaning solution used here.

An alkaline concentration of the alkaline cleaning solution is preferably 0.5 mass% or more but no greater than a saturated concentration or less. In addition, the temperature of the alkaline cleaning solution is preferably 5°C or more and 80°C or less. The temperature of the cleaning solution is preferably 5°C or more to an extent where freezing is prevented. Moreover, even when the temperature is too high, the gallium removal effect is not changed, thus a temperature of 80°C or less is sufficient. Furthermore, the time for cleaning using the alkaline cleaning solution is preferably 10 seconds or more and 1 hour or less. The Ga can be removed selectively with greater stability and reliability by setting the time of cleaning to 10 seconds or more. Even when the time for cleaning is too long, the gallium removal effect is not changed, thus 1 hour or less is sufficient. Moreover, by appropriately combining the above alkaline concentration, the temperature of the alkaline cleaning solution, and the time for cleaning, the gallium can be removed selectively with further stability and reliability.

As described above, the LED chips that have been transferred on the receptor substrate have gallium on a surface opposite to the receptor substrate. Additionally, each LED chip has the bump on the side to adhere to the receptor substrate. The gallium on the surface opposite to the receptor substrate can be easily removed by cleaning using the alkaline cleaning solution.

In the method for producing an LED mounting substrate according to the present invention, the bump has been preferably formed using lead-free solder. It is more preferable that the bump contains, as a main component, at least one selected from SnAgCu (SAC) - based alloy, SnZnBi-based alloy, SnCu-based alloy, SnAgInBi-based alloy, SnZnAl-based alloy, and indium. In particular, when such a bump is used, dissolution or alteration (damage) to the bump can be stably and reliably prevented even when cleaned using the alkaline cleaning solution.

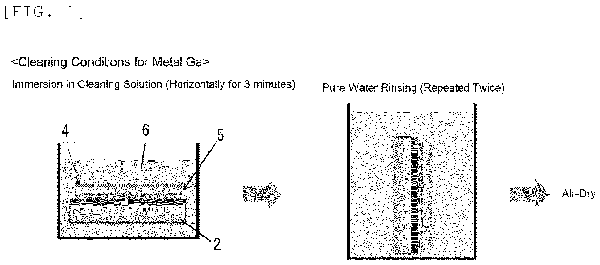

FIG. 1 shows an example of the step of cleaning the LED chip using the alkaline cleaning solution. As shown in FIG. 1, in the step of cleaning the LED chips using the alkaline cleaning solution of the method for producing an LED mounting substrate according to the present invention, the LED chips 5 transferred onto the receptor substrate 2 are preferably cleaned by immersing the LED chip along with the receptor substrate 2 in an alkaline cleaning solution 6. This enables the selective removal of gallium 4, more easily, reliably, and stably. More specifically, as shown in FIG. 1, the receptor substrate 2, on which the LED chips 5 have been transferred, can be immersed in a cleaning vessel filled with the alkaline cleaning solution 6, then rinsed with pure water or the like for an appropriate number of times, and dried (air-dried).

### [Cleaning Method for Cleaning LED]

The present invention also provides a cleaning method for cleaning an LED chip isolated from a sapphire substrate by laser lift-off in which an alkaline cleaning solution is used for cleaning. According to such a cleaning method, only gallium can be selectively removed with ease without dissolving or altering a metal other than gallium, as a result, the connection failure of the LEDs can be decreased. Moreover, in the cleaning method according to the present invention, the LED chips have been preferably transferred on a receptor substrate. The specific example of the cleaning method for cleaning an LED chip is the same as the description using the above FIG. 1.

### [Cleaning Method for Selectively Removing Gallium from Component]

The present inventors found out that by cleaning an LED chip isolated from a sapphire substrate by laser lift-off with an alkaline cleaning solution, only gallium can be selectively removed without dissolving or altering a metal other than gallium, as described above. In addition, as a result of further studies, the present inventors found out that even when the gallium is selectively removed from not only the LED chips but also components having both the gallium and the metal other than the gallium on a surface thereon, the gallium can be selectively removed without dissolving or altering the metal other than the gallium by a very easy method of cleaning the components using an alkaline cleaning solution.

In such a cleaning method, in particular, the alkaline cleaning solution preferably comes in contact with the gallium and the metal other than the gallium during cleaning. The gallium can be selectively removed without dissolving or altering the metal other than the gallium by an easier method.

Moreover, it is preferred that the component to be cleaned has a substrate-shape and is fixed onto a different substrate during cleaning; the gallium is preferably present on a surface opposite to the different substrate side of the component; and the metal other than the gallium is preferably present on the different substrate side of the component.

The metal other than the gallium preferably contains at least one selected from the group consisting of aluminum, copper, zinc, silver, indium, tin, and bismuth. The metal other than the gallium more preferably contains at least one selected from the group consisting of copper, silver, indium, and tin. The metal other than the gallium further preferably contains copper, silver, and tin. This is because, when such metals are used for the metal other than the gallium, the dissolution or alteration during the cleaning is more stably suppressed.

Note that, in the present invention, the gallium, being an object to be removed, may be present in a state of 100% purity, or may be present in a state of oxide or nitride. Moreover, these states may exist together. When the proportion of the gallium in the object to be removed accounts for 50 volume% or more, preferably 70 volume% or more, and more preferably 90 volume% or more, that removal is effective.

Moreover, in the present invention, it is more effective when a selectivity, which is the ratio of the dissolving rate of the gallium to the dissolving rate of the other metal, is higher. This selectivity may be 1 or more, 5 or more, or 10 or more. Regarding a working environment and workability, the upper limit of this selectivity may be approximately 100, approximately 50, or approximately 20.

Here, the dissolving rate (um/minutes) can be measured by a method shown in the following (A) to (G), for example.
(A) An alkaline cleaning solution for cleaning, for example, 1 liter of a 5 mass% aqueous solution of KOH (potassium hydroxide), is provided.
(B) A substrate made of the gallium and a substrate made of a metal other than the gallium, each in a plate shape with dimensions of 1 cm in length, 1 cm in width, and 1 mm in thickness are provided, and respective masses W0 thereof are measured. When a native oxide film and the like is present on a surface of the substrates, the film thereof is removed in advance.
(C) The alkaline aqueous solution is divided into two containers, 500 milliliters each, and intended cleaning conditions are applied. For example, the substrate made of the gallium and the substrate made of the metal other than the gallium are immersed in each container having the alkaline aqueous solution adjusted to 25°C for 3 minutes. Positioning of each substrate in each container during immersion is adjusted to ensure that dissolving amounts are not affected by extreme differences between the substrates. Moreover, in the case where the substrate is completely dissolved, the thicknesses of the substrates provided in the above (B) are increased.
(D) Each substrate is taken out from the alkaline aqueous solution and cleaned at room temperature.
(E) Masses W1 of each substrate after cleaning are measured.
(F) The dissolving rate (um/minutes) is calculated based on difference between the above mass W0 and the above mass W1, along with specific gravity of each substrate. In this case, it is calculated assuming that the dissolving occurs only in a thickness direction of the substrate.
(G) The selectivity is calculated according to a following formula using obtained dissolving rate values. Selectivity = Dissolving Rate of Gallium (um/minutes) / Dissolving Rate of Metal other than Gallium (um/minutes)

In addition, when a contact area between the metal other than the gallium and the cleaning solution is sufficiently smaller than a contact area between the gallium and the cleaning solution, the selectivity may be less than 1.

Although the cleaning method for the object, in which the gallium and the metal other than the gallium are present, is described above, this can be applied to the cleaning method for an object, in which a combination of different metals is present by employing the technical concept of the present invention. For example, this includes the cleaning method for an object in which a combination of a specific metal and a metal proximate to the specific metal in the periodic table (e.g., metals within a range of periods within ±2 and groups within ±2 relative to the specific metal) is present.

### EXAMPLE

Hereinafter, the present invention will be specifically described with reference to Examples. However, the present invention is not limited thereto.

LED chips having a bump formed on one surface and transferred to a receptor substrate by laser lift-off were provided and performed a cleaning step. The LED chips were provided using an In (indium) bump and a SAC bump, respectively.

### (Evaluation before Cleaning)

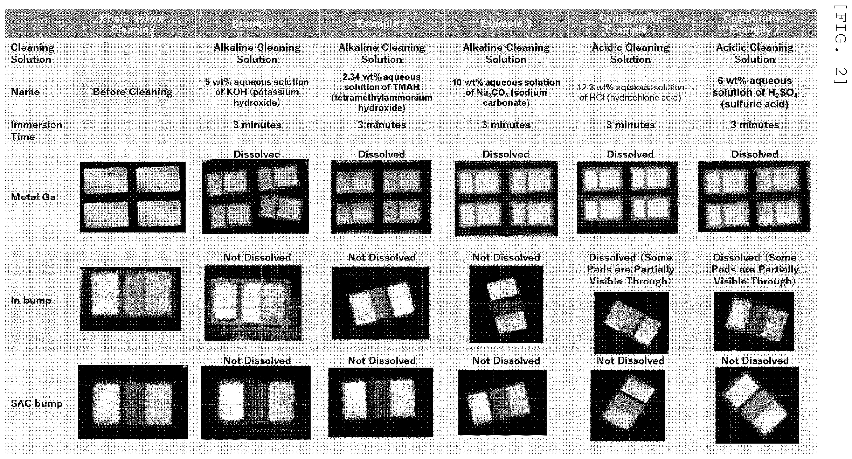

First, when the LED chips were observed using an optical microscope before cleaning, it was confirmed that gallium adhered on a surface opposite to the bump-formed surface of the LED chips. Note that the presence or absence of adherence of the gallium after cleaning, or the presence or absence of dissolution of the bump by cleaning can be distinguished by difference in color. FIG. 2, "Photographs before Cleaning", shows the results of the observation.

### (Example 1)

Cleaning was performed using a 5 mass% aqueous solution of KOH (potassium hydroxide) which was an alkaline cleaning solution as a cleaning solution. LED chips, along with a receptor substrate on which the LED chips were transferred, were immersed in the cleaning solution and cleaned for a cleaning time of 3 minutes at a cleaning temperature of 25°C (room temperature). The LED chips were observed using an optical microscope as in an evaluation before cleaning, the presence or absence of adherence of the gallium, and the presence or absence of generation of dissolution of the bump were evaluated.

### (Example 2)

Cleaning and evaluation were performed as in Example 1 except that a 2.34 mass% aqueous solution of TMAH (tetramethylammonium hydroxide), which was an alkaline cleaning solution, was used as a cleaning solution.

### (Example 3)

Cleaning and evaluation were performed as in Example 1 except that a 10 mass% aqueous solution of Na₂CO₃ (sodium carbonate), which was an alkaline cleaning solution, was used as a cleaning solution.

### (Comparative Example 1)

Cleaning and evaluation were performed as in Example 1 except that a 12.3 mass% aqueous solution of HCl (hydrochloric acid), which was an acidic cleaning solution, was used as a cleaning solution.

### (Comparative Example 2)

Cleaning and evaluation were performed as in Example 1 except that a 6 mass% aqueous solution of H₂SO₄ (sulfuric acid), which was an acidic cleaning solution, was used as a cleaning solution.

FIG. 2 shows evaluation results. It was confirmed that metal Ga adhered on LED chips was removed regardless of type of the cleaning solutions, in Examples 1 to 3. On the other hand, neither an In bump nor a SAC bump did not generate dissolution due to cleaning. It was found that cleaning with an alkaline cleaning solution allowed a selective dissolution or removal of only metal Ga. In contrast, it was confirmed that in Comparative Examples 1 and 2 where cleaning was performed using the acidic cleaning solution, the In bump was dissolved. However, the dissolution of the SAC bump was not confirmed.

### (Example 4)

A SAC bump was immersion-treated in an alkaline cleaning solution (5 mass% an aqueous solution of KOH (potassium hydroxide)) as in Example 1, then applied with an IPA solution of abietic acid, a component of flux, and dried at 40°C. Subsequently, the SAC bump was heated to 250°C on a hot plate. FIG. 3 shows evaluation results by using an optical microscope. As shown in FIG. 3, color of the bump was changed after heating to 250°C, indicating that the SAC bump was dissolved. The flux is used for the purpose of improving fusibility or wettability of a solder by reducing an oxide film on the bump surface, thereby ensuring electrical connection. Consequently, the fusion of the SAC bump by the treatment as in Example 4 indicates that the cleaning treatment in Example 4 did not cause the alteration of the SAC bump. Note that the composition of the SAC bump used was Sn=96.5 mass%, Ag=3.0 mass%, Cu=0.5 mass%.

### (Comparative Example 3)

A SAC bump was immersion-treated in an acidic cleaning solution (12.3 mass% aqueous solution of HCl (hydrochloric acid)) as in Comparative Example 1, then applied with an IPA solution of abietic acid, a component of flux, and dried at 40°C. Subsequently, the SAC bump was heated to 250°C on a hot plate. FIG. 4 shows evaluation results by using an optical microscope. As shown in FIG. 4, color of the bump was not changed before and after heating to 250°C, indicating that the SAC bump was not dissolved. This is considered to be due to a change in alloy composition of Sn, Ag, and Cu and an increase in a melting point by cleaning with the acidic cleaning solution, altering from a state of the bump normally used. That is, it was found that the SAC bump thereof was not dissolved by the acidic cleaning solution, but the composition and the like thereof were altered, resulting in the change in electrical characteristics of the LED chip. This suggested a generation of connection failure.

As described above, according to Examples of the present invention, it was found that only gallium can be removed without dissolving or altering a metal other than the gallium by cleaning.

The present description includes the following embodiments.
[1]: A method for producing an LED mounting substrate, the method comprising a step of cleaning an LED chip, being transferred from on top of a sapphire substrate onto a receptor substrate by laser lift-off, with an alkaline cleaning solution.
[2]: The method for producing an LED mounting substrate according to the above [1], wherein
   gallium is present on a surface opposite to the receptor substrate of the LED chip that is transferred onto the receptor substrate, and
   the gallium is removed in the step of cleaning.
[3]: The method for producing an LED mounting substrate according to the above [1] or [2], wherein
   an alkaline concentration of the alkaline cleaning solution is 0.5 mass% or more but no greater than a saturated concentration or less.
[4]: The method for producing an LED mounting substrate according to the above[1], [2], or [3], wherein
   a temperature of the alkaline cleaning solution is 5°C or more and 80°C or less.
[5]: The method for producing an LED mounting substrate according to the above[1], [2], [3], or [4], wherein
   time for cleaning using the alkaline cleaning solution is 10 seconds or more and 1 hour or less.
[6]: The method for producing an LED mounting substrate according to the above[1], [2], [3], [4], or [5], wherein
   a surface of the LED chip on a side to be adhered to the receptor substrate has a bump.
[7]: The method for producing an LED mounting substrate according to the above [6], wherein
   the bump has been formed using lead-free solder.
[8]: The method for producing an LED mounting substrate according to the above [6] or [7], wherein
   the bump contains, as a main component, at least one selected from SnAgCu-based alloy, SnZnBi-based alloy, SnCu-based alloy, SnAgInBi-based alloy, SnZnAl-based alloy, and indium.
[9]: The method for producing an LED mounting substrate according to the above [1], [2], [3], [4], [5], [6], [7], or [8], wherein
   the LED chip transferred onto the receptor substrate is cleaned by immersing the LED chip along with the receptor substrate in the alkaline cleaning solution.
[10]: A cleaning solution for cleaning an LED chip after transferring thereof onto a receptor substrate by laser lift-off from a sapphire substrate where the LED chip is provided thereon, wherein
   the cleaning solution is alkaline.
[11]: The cleaning solution according to the above [10], wherein
   the cleaning solution has a pH ranging from 9.5 to 14.0.
[12]: The cleaning solution according to the above [10], or [11], wherein
   the cleaning solution is an aqueous solution containing at least one selected from the group consisting of sodium hydroxide, potassium hydroxide, ammonium hydroxide, magnesium hydroxide, tetramethylammonium hydroxide, tetrabutylammonium hydroxide, sodium carbonate, sodium hydrogencarbonate, and potassium acetate.
[13]: A cleaning method for cleaning an LED chip isolated from a sapphire substrate by laser lift-off, wherein
   an alkaline cleaning solution is used for cleaning.
[14]: The cleaning method according to the above [13], wherein
   the LED chip has been transferred onto a receptor substrate.
[15]: A cleaning method for selectively removing gallium from a component having gallium and a metal other than the gallium on a surface, wherein
   the component is cleaned using an alkaline cleaning solution.
[16]: The cleaning method according to the above [15], wherein
   the alkaline cleaning solution comes in contact with the gallium and the metal other than the gallium during cleaning.
[17]: The cleaning method according to the above [15], or [16], wherein
   the component has a substrate-shape, and is fixed to a different substrate during cleaning,
   the gallium is present on a surface opposite to the different substrate side of the component, and
   the metal other than the gallium is present on the different substrate side of the component.
[18]: The cleaning method according to the above [15], [16], or [17], wherein
   the metal other than the gallium contains at least one selected from the group consisting of aluminum, copper, zinc, silver, indium, tin, and bismuth.
[19]: The cleaning method according to the above [15], [16], [17], or [18] wherein
   the metal other than the gallium contains at least one selected from the group consisting of copper, silver, indium, and tin.
[20]: The cleaning method according to the above [15], [16], [17], [18], or [19], wherein
   the metal other than the gallium contains copper, silver, and tin.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing an LED mounting substrate, the method comprising a step of cleaning an LED chip, being transferred from on top of a sapphire substrate onto a receptor substrate by laser lift-off, with an alkaline cleaning solution.

2. The method for producing an LED mounting substrate according to claim 1, wherein
gallium is present on a surface opposite to the receptor substrate of the LED chip that is transferred onto the receptor substrate, and
the gallium is removed in the step of cleaning.

3. The method for producing an LED mounting substrate according to claim 1, wherein
an alkaline concentration of the alkaline cleaning solution is 0.5 mass% or more but no greater than a saturated concentration or less.

4. The method for producing an LED mounting substrate according to claim 1, wherein
a temperature of the alkaline cleaning solution is 5°C or more and 80°C or less.

5. The method for producing an LED mounting substrate according to claim 1, wherein
time for cleaning using the alkaline cleaning solution is 10 seconds or more and 1 hour or less.

6. The method for producing an LED mounting substrate according to claim 1, wherein
a surface of the LED chip on a side to be adhered to the receptor substrate has a bump.

7. The method for producing an LED mounting substrate according to claim 6, wherein
the bump has been formed using lead-free solder.

8. The method for producing an LED mounting substrate according to claim 6, wherein
the bump contains, as a main component, at least one selected from SnAgCu-based alloy, SnZnBi-based alloy, SnCu-based alloy, SnAgInBi-based alloy, SnZnAl-based alloy, and indium.

9. The method for producing an LED mounting substrate according to any one of claims 1 to 8, wherein
the LED chip transferred onto the receptor substrate is cleaned by immersing the LED chip along with the receptor substrate in the alkaline cleaning solution.

10. A cleaning solution for cleaning an LED chip after transferring thereof onto a receptor substrate by laser lift-off from a sapphire substrate where the LED chip is provided thereon, wherein
the cleaning solution is alkaline.

11. The cleaning solution according to claim 10, wherein
the cleaning solution has a pH ranging from 9.5 to 14.0.

12. The cleaning solution according to claim 10 or 11, wherein
the cleaning solution is an aqueous solution containing at least one selected from the group consisting of sodium hydroxide, potassium hydroxide, ammonium hydroxide, magnesium hydroxide, tetramethylammonium hydroxide, tetrabutylammonium hydroxide, sodium carbonate, sodium hydrogencarbonate, and potassium acetate.

13. A cleaning method for cleaning an LED chip isolated from a sapphire substrate by laser lift-off, wherein
an alkaline cleaning solution is used for cleaning.

14. The cleaning method according to claim 13, wherein
the LED chip has been transferred onto a receptor substrate.

15. A cleaning method for selectively removing gallium from a component having gallium and a metal other than the gallium on a surface, wherein
the component is cleaned using an alkaline cleaning solution.

16. The cleaning method according to claim 15, wherein
the alkaline cleaning solution comes in contact with the gallium and the metal other than the gallium during cleaning.

17. The cleaning method according to claim 15, wherein
the component has a substrate-shape, and is fixed to a different substrate during cleaning,
the gallium is present on a surface opposite to the different substrate side of the component, and
the metal other than the gallium is present on the different substrate side of the component.

18. The cleaning method according to claim 15, wherein
the metal other than the gallium contains at least one selected from the group consisting of aluminum, copper, zinc, silver, indium, tin, and bismuth.

19. The cleaning method according to claim 15, wherein
the metal other than the gallium contains at least one selected from the group consisting of copper, silver, indium, and tin.

20. The cleaning method according to any one of claims 15 to 19, wherein
the metal other than the gallium contains copper, silver, and tin.
